# EUROPEAN PATENT SPECIFICATION

(11) **EP 3 912 111 B1**
(45) Date of publication and mention of the grant of the patent: **13.09.2023**
(21) Application number: 20703674.0
(22) Date of filing: 13.01.2020
(51) Int. Cl.: G06Q 10/0635, G05B 17/02, H04L 12/28

(54) **SYSTEM AND METHOD FOR SIMULATING SYSTEM OPERATION CONDITIONS**
SYSTEM UND VERFAHREN ZUR SIMULATION VON SYSTEMBETRIEBSBEDINGUNGEN
SYSTÈME ET PROCÉDÉ DE SIMULATION DE CONDITIONS DE FONCTIONNEMENT D'UN SYSTÈME

(30) Priority: 18.01.2019 US 201916251382
(43) Date of publication of application: 24.11.2021
(73) Proprietor: Siemens Industry, Inc., Alpharetta, GA 30005 (US)
(72) Inventor: CASILLI, Chris, Morriston, Florida 32668 (US); SONGKAKUL, Pornsak, Mequon, Wisconsin 53092 (US)
(74) Representative: Siemens Patent Attorneys
(86) International application number: PCT/US2020/013298
(87) International publication number: WO 2020/150130

(56) References cited:
- US-A1- 2014 222 394
- US-A1- 2017 315 522

## Description

### FIELD OF THE INVENTION

Aspects of the present invention generally relate to building automation systems and, more particularly, systems and methods for simulating system operation conditions of a building or group of buildings.

### BACKGROUND

Building automation systems provide the capability of managing many building management components from a central front-end interface or group of interfaces. These building management components include building equipment for lighting, power, heating, ventilation, air conditioning, fire safety, and security. The building automation systems offer operational and sustainability benefits for building developers, managers, and occupants.

When developing data analytic applications or optimization applications for building automation systems, data sets that depict actual system and operational data are helpful to analyze and develop these applications. On the other hand, during the development phase, it is not economically feasible to have a development environment connected to actual system controllers since any actions taken by the applications during the development phase may unintentionally affect the operation of the actual systems.

BACnet simulators currently available on the market generate random values for each individual BACnet control point. These randomly generated values are only helpful for alarm limit testing and event enable/disable, so the capabilities of existing BACnet simulators are limited. Actual operating data needed for the development of applications may be created manually by-hand by an application developer, but it becomes the responsibility and difficult tasks of the developer to read such data and write the data to simulate operating values. Thus, manual creation of actual operating data is very cumbersome and hinders the ability to provide operating data and conditions that are closed to actual system operation in real time or semi-real time. The American application US20170315522A1 discloses a virtual simulator and a building management system including the same. The virtual simulator is connected to a plurality of physical controllers, controlling at least one piece of equipment in a building, and to a control server, controlling the plurality of physical controllers, for simulating operations of the plurality of physical controllers, wherein the virtual simulator comprises a plurality of virtual controllers, each virtual controller of the plurality of virtual controllers corresponding to a corresponding physical controller of the plurality of physical controllers and being configured to perform a same function as the corresponding physical controller, wherein the plurality of virtual controllers are configured to communicate with the plurality of physical controllers and the control server by using different Internet protocol (IP) addresses; and a virtual controller management agent configured to perform at least one among generation, deletion, execution, termination, detection, and control of the plurality of virtual controllers.

### SUMMARY

Briefly described, there are described a building simulation system of a building automation system for simulating system operation conditions of one or more building environments. The building simulation system provides simulated system and operation data and/or conditions to data consumers for developing or testing of analytic applications, optimization applications, devices, systems, and other components of a building automation system. Simulated data may be utilized during development to avoid adverse effects to the operation of the building automation system and its components. Simulated data may also allow for targeted analyses and testing of specific faults and conditions of interest. Simulated data further allows for timing management of a simulated system and operation in order to accelerate development of components for the building automation system.

The building simulation system operates on a management device of the building automation system to provide various features. The system provides a simulated environment, which may include an import mechanism to parse the data of a building model. For example, the system includes the capability of playing back data from an actual system for the purpose of repeating tests necessary for product and system development. The system also provides a system and method to automatically generate points for the simulated building automation system for each associated data entry or data set. The system further enables the ability to playback simulated data values through various points over particular time intervals, in which the playback mechanism instantiates the simulated data model by a standard communication protocol for a building automation network, such as BACnet. Other devices and systems may observe the simulated data for the building automation system as if the data represents an actual system.

The building simulation system is also built on a flexible and scalable framework supporting simulation, concurrency, distribution, and fault tolerance. In particular, the framework provides flexibility in managing the type of simulated data and manner in which the simulated data may be provided to data consumers. The framework also provides scalability of the simulated system operation conditions provided to the data consumers such that a wide range of environments, from individual systems to large scale buildings or municipalities, may be represented.

One aspect of the building simulation system for simulating system operation conditions associated with a building automation system comprises a memory, a processor, and a communication component. The memory has a configuration file associated with one or more virtual nodes. The configuration file includes device properties of a field device simulated by a building simulation system executing the point simulator service. The configuration file also references a data file that includes time intervals and one or more simulated system operation conditions of one or more points associated with the field device for the time intervals. The processor is coupled to the memory, and the processor executes instructions for generating a virtual node hosting environment, creating the virtual node or nodes in the virtual hosting environment, and generating simulated operation data of the point or points from the building simulation system executing the point simulator service based on the data file. The building simulation system includes point simulator servers in which each point simulator server corresponds to a point of the one or more system operation condition identified by the data file. The communication component is coupled to the processor, and the communication component provides the simulated operation data to a data consumer.

Others aspects include a method for simulating system operation conditions of one or more building environments and a non-transitory computer readable medium including executable instructions which, when executed, cause one or more processors to provide for simulation of system operation conditions. A virtual node hosting environment is generated by a processor. One or more virtual nodes are created in the virtual node hosting environment to communicate with a data consumer by a communication component. The virtual node hosting environment allocates memory and processor resources to the virtual node or nodes. A building simulation system is configured by the processor in the virtual node or nodes based on a configuration file associated with the virtual node or nodes. The configuration file includes device properties of a field device simulated by the building simulation system. The configuration file also references a data file that includes time intervals and simulated system operation conditions of one or more points associated with the field device for the time intervals. Simulated operation data of the point or points are generated, by the processor, from the building simulation system based on the data file. The building simulation system includes point simulator servers in which each point simulator server corresponds to one or more system operation conditions identified by the data file. The communication component provides the simulated operation data to the data consumer.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects.
FIG. 1 illustrates schematically a building simulation system that includes a building simulation system for simulating system operation conditions of a building or group of buildings in accordance with an example embodiment of the present invention.
FIG. 2 is a block diagram representing example components of a management device of the building automation system of FIG. 1 as well as example components of a field device in accordance with the present invention.
FIG. 3 is a schematic view of example operational components of a management device in accordance with the present invention.
FIG. 4 is a schematic view of example operational components of a point simulator service of a virtual node in accordance with the present invention.
FIG. 5 illustrates schematically an example operation of a management device in accordance with the present invention.
FIG. 6A represents an example configuration file in accordance with the present invention.
FIG. 6B represents an example data file in accordance with the present invention.

### DETAILED DESCRIPTION

To facilitate an understanding of embodiments, principles, and features of the present invention, they are explained hereinafter with reference to implementation in illustrative embodiments. In particular, they are described in the context of a building simulation system for simulating system operation conditions of a building or group of buildings. Embodiments of the present invention, however, are not limited to use in the described devices or methods.

The components and materials described hereinafter as making up the various embodiments are intended to be illustrative and not restrictive. Many suitable components and materials that would perform the same or a similar function as the materials described herein are intended to be embraced within the scope of embodiments of the present invention.

The building simulation system may be used to provide real time collaboration of external reference data between building automation systems and external data sources or consumers. The building simulation system may also be used to bring data from Internet sources. The data may be presented to the building automation systems as virtual nodes and objects as well as unlocking point data of the building automation systems for use by other network-based data consumers.

For example, to a data consumer, each virtual node is a digital representation of a physical field device and its associated points. The data consumer observes data as if the data consumer is physically connected to field device controlling physical equipment, but in fact the data consumer is observing only virtual copies. The data consumer may retrieve data, while having minimal impact or risk to the physical devices and systems.

The building simulation system includes as many of these virtual nodes as necessary to model the physical system. One advantage of the building simulation system is this ability to scale to immense size, as needed to digitally represent the physical world in a building, campus, or even a large enterprise. The maximum number of points allowed in a virtual node varies because it is dependent on the user-configured variables of polling times (i.e., polling intervals) and the time periods between individual events corresponding to points (i.e., separation times).

With ability to represent simulated building and system operating data as if the data were provided by non-simulated entities, the building automation system provides simulated data in semi-real time operating conditions similar to data provided by the non-simulated devices and systems. As a result, the building automation system may enhance and validate analytic applications, such as Fault Detection and Diagnostic Systems (FDD). According to the invention, the building model of the building automation system includes various simulated conditions and fault events that may be used for testing new data analytics and optimization applications. The play back of these fault events, via the virtual node hosting environment, validates the detection capabilities of monitoring systems by detecting the various played back faults. The play back capabilities may also be used to feed data for automated testing process such that new applications may be consistently tested with the same data set to ensure the accuracy and quality of the applications being developed.

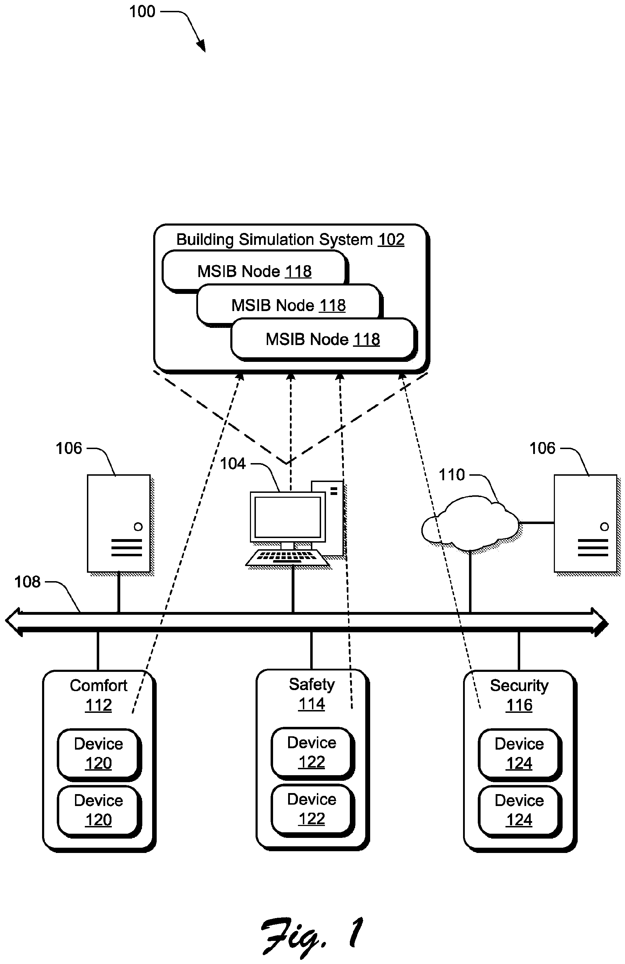

Referring to FIG. 1, there is illustrated a building automation system 100 for implementing a building simulation system 102 in a management device 104, which is a component of the building automation system. The building simulation system 102 serves data to a destination, such as a data consumer 106. A data consumer 106 may be any type of device or system that may benefit from simulated operation data of one or more field devices (e.g., devices 120, 122 and/or 124) of a building automation system 100. The management device 104 may communicate with the data consumer 106 directly, such as through a communication bus 108, or via an internal or external network, such as a cloud system 110. Examples of data consumers 106 include, but are not limited to, product development systems, energy and sustainability management systems, and remote service systems. Product development systems develop and test analytic applications, optimization applications, devices, systems, and other components of a building automation system. Energy and sustainability management systems analyze incoming data for fault detection and diagnostics as well as energy efficiency and sustainability reporting. Remote service systems provide a range of services via a remote connection, such as capturing and adjusting system parameters, performance optimization, data monitoring, and other services to manage a building automation system 100. In addition to serving data to destinations, the building simulation system 102 may also collect data from a source for some embodiments. Examples of sources include, but are not limited to, building network servers, external networks (such as the Worldwide Web), and external services (such as the National Oceanic and Atmospheric Administration (NOAA) Weather Station).

As shown in FIG. 1, the building automation system 100 may be an environmental control system configured to control one or more environmental parameters for one or more building environments, such as temperature, humidity, ventilation, lighting, fire safety, security, and the like. For example, the building automation system 100 may comprise a communication bus 108 to manage component connectivity and management for the system. For one embodiment, the example building automation system 100 may comprise one or more management devices, such as a server or workstation 104 that allows the setting and/or changing of various controls of the system and a data consumer 106. While a brief description of the building automation system 100 is provided below, it will be understood that the building automation system 100 described herein is only one example of a particular form or configuration for a building automation system and that the system 100 may be implemented in any other suitable manner without departing from the scope of this disclosure.

As stated above, the building automation system 100 includes a building simulation system 102. The building simulation system 102 includes various components described herein, and FIG. 1 illustrates only one part of the building simulation system, namely the virtual node or nodes supporting the point simulator service. Examples of virtual nodes that support the point simulator service are shown in FIG. 1 as Middleware Services for Integrated Buildings (MSIB) nodes 118 and described in U.S. Patent No. 10,129,046 B1, issued November 13, 2018, titled "Fault Tolerant Services for Integrated Building Automation Systems". The virtual nodes, such as the MSIB nodes 118, are virtual representations of simulated data available in physical field devices of the building automation system 100. The points of these virtual nodes are available to be discovered as network objects and polled by testing, monitoring or analytics applications of data consumers 106.

For the illustrated embodiment, the building automation system 100 provides connectivity to subsystems for various environmental parameters such as components of comfort sub-systems 112, safety sub-systems 114, and security sub-systems 116. For example, comfort sub-systems 112 may include various devices 120 for monitoring and controlling heating, cooling, ventilation, and lighting of areas within a building or group of buildings. Examples of comfort devices include, but are not limited to, stations, field panels, field controllers, field devices, light fixtures, and the like. Similarly, safety sub-systems 114 may include various devices 122 for monitoring and controlling fire protection for areas within a building or a group of buildings. Examples of safety devices include, but are not limited to, controllers, control panels, detectors, alarm systems, video surveillance cameras, and the like. Further, security sub-systems 116 may include various devices 124 for monitoring and controlling activities within a building or group of buildings. Examples of security devices include, but are not limited to, video surveillance cameras, motion detectors, portal controls, and the like. Some devices 120 may communicate through the communication bus 108, and some devices 122 may communicate directly or wirelessly with other devices. It is to be understood that the system 100 may comprise any suitable number of any of components 120-124 based on a particular configuration for each building or group of buildings.

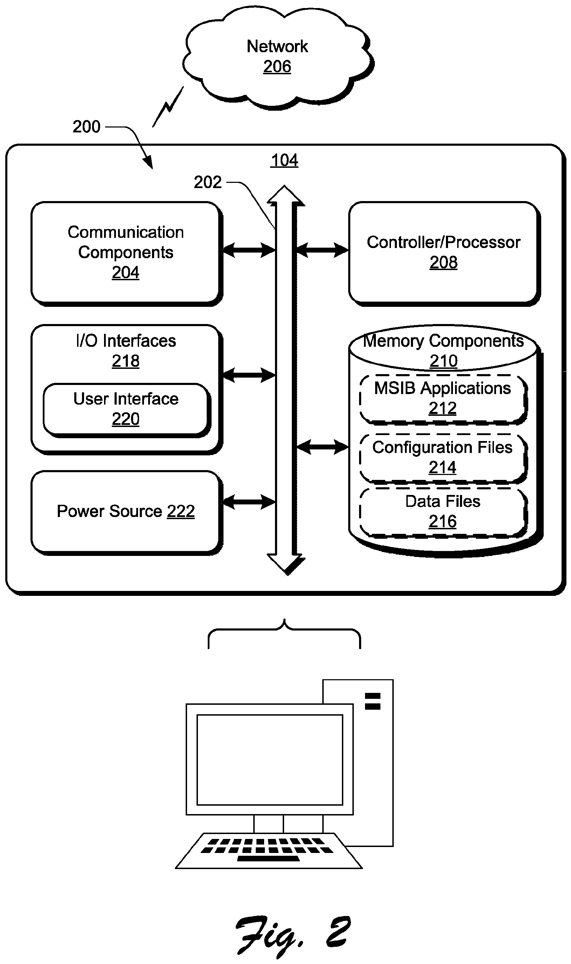

FIG. 2 is an example representation of the various device components 200 of the management device 104 of the building automation system 100. The management device 104 may be a server, a workstation, a remote device, or other type of device for management and control of one or more aspects of the building automation system 100. The device components 200 of the management device 104 comprise one or more communication components 204 communicate with other entities via a wired or wireless network 206, one or more controllers or processors 208, and one or more memory components 210. The communication component 204 of the example device components 200 may utilize wireless technology for communication, such as, but are not limited to, satellite-based and cellular-based communications and their variants as well as wireless local area network (WLAN) communication and their variants, such as infrastructure, peer-to-peer, ad hoc, bridge, and wireless distribution-based communications. Examples of WLAN communications include, but are not limited to, IEEE 802.11 (Wi-Fi), IEEE 802.16 (WiMAX), Bluetooth, BLE, and ZigBee. Wireless communications may further include other forms of communication such as microwave or infrared technology (IR). The communication component 204 of the example device components 200 may also utilize, in addition to or in the alternative, wired technology for communication, such as transmission of data over a physical conduit, e.g., an electrical cable or optical fiber cable.

The processor 208 may execute code and process data received other components of the device components 200, such as information received at the communication component 204 or stored at the memory component 210. The code associated with the building automation system 100 and stored by the memory component 210 may include, but is not limited to, operating systems, applications, modules, drivers, and the like. An operating system includes executable code that controls basic functions of the management device 104, such as interactions among the various components of the device components 200, communication with external devices via the communication component 204, and storage and retrieval of code and data to and from the memory component 210. Each application includes executable code to provide specific functionality for the processor 208 and/or remainder of the management device 104. Examples of applications executable by the processor 208 and stored by the memory component 210 include, but are not limited to, building simulation applications, such as MSIB applications 212. Data is information that may be referenced and/or manipulated by an operating system or application for performing functions of the management device 104. Examples of data associated with the building automation system 100 and stored by the memory component 210 may include, but are not limited to, configuration files associated with one or more virtual nodes, data files referenced by the configuration files, and the like.

The device components 200 of each management device 104 may further comprise one or more input and/or output components (I/O interfaces) 218. The I/O interfaces 218 of the device components 200 may include a variety of video, audio, and/or mechanical components. The I/O interfaces 218 of each management device may comprise a user interface 220 for interaction with a user of the management device. The user interface 220 may include a combination of hardware and software to provide a user with a desired user experience. For example, the user interface 220 may include one or more input components to allow the user to enter information and one or more output components to provide information to the user. Although the user interface 220 may include all input components and all output components of the I/O interface 218, the user interface may also be directed to a specific subset of input components and/or output components.

The device components 200 may further comprise a power source 222, such as a power supply or a portable battery, for providing power to the other device components 200 of each management device 104 of the building management system 100.

It is to be understood that FIG. 2 is provided for illustrative purposes only to represent examples of the device components 200 of a management device 104 and is not intended to be a complete diagram of the various components that may be utilized by the device. Therefore, management device 104 may include various other components not shown in FIG. 2, may include a combination of two or more components, or a division of a particular component into two or more separate components, and still be within the scope of the present invention.

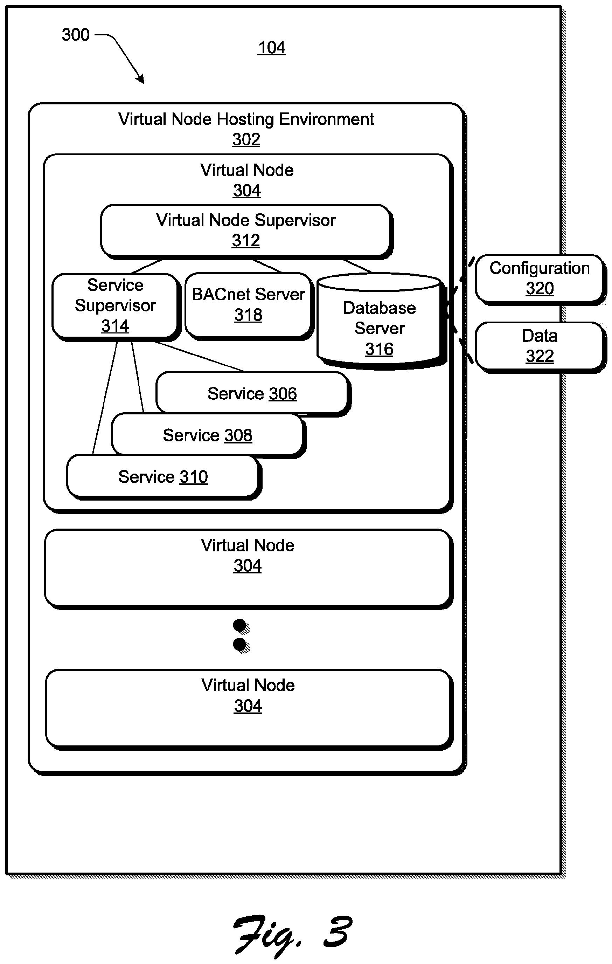

Referring to FIG. 3, there is shown a management device 104 that includes an embodiment of the building simulation system 300 consistent with the building simulation system 102 described in detail herein. The building simulation system 300 comprising a virtual node hosting environment 302 that operates on a designated management device 104 and operates in the background to continuously process services for one or more virtual nodes 304. The management device 104 may also include a user interface 220 as shown in FIG. 2, such as a web browser, that may provide for configuration and maintenance of the virtual node hosting environment 302 and the virtual nodes operated in the hosting environment. The virtual nodes 304 may be digital representations of simulated devices, such as field devices 112, 114, 116, as well as the points associated with the simulated devices. Since the operation data is simulated, the field devices 112, 114, 116 of the building simulation system 102 may be simulated field devices, based on actual field devices, or a combination thereof.

The virtual node hosting environment 302, and any components thereof, may scan the building automation system 100 for field devices 112, 114, 116 to create data files which may be used as import files for configuring and operating the building simulation system 300. The data files may include, but are not limited to, points associated with the building automation system and their corresponding values associated with system operation conditions over a particular period of time. In particular, the virtual node hosting environment 302 may send out a discovery message throughout the building automation system 100 and create an initial list of field devices that respond. The hosting environment 302 may then obtain an object list of each field device and read the properties of each supported object of each field device. The learned information may be collected in a data file and stored in memory, one for each device or multiple devices. When scanning is complete, a summary file with all of the field devices may be created as well. The scanning may be limited to specific devices or include the entire network. The various object types implemented in the building simulation system and that correspond to the discovered devices include, but are not limited to, an analog type, a binary type, a multi-state type, and a pulse converter type.

As shown in FIG. 3, each virtual node 304 of a virtual node hosting environment 302 may manage one or more services 306, 308, 310 to facilitate communication of data with the various devices of the building automation system 100, communication of data with data consumers 106, and processing and/or manipulating data for the various devices and the data consumers. In this manner, the building simulation system may scale as needed to digitally represent the various services provided by the physical world in a building, campus, or even a large enterprise. An example of a service 306, 308, 310 is a point simulator service as described herein. Other examples of a service 306, 308, 310 include, but are not limited to, services for implementing specific protocols to access equipment, panels and points, collect periodic data from equipment, panels and points, monitor operational conditions of equipment, panels and points, and the like. Thus, each virtual node 304 of the virtual node hosting environment 302 may run and manage a point simulator service. For example, a second system consistent with the point simulator service as described herein may be simulated at a second virtual node, concurrently with a first system simulated at a first virtual node, in which the systems and virtual nodes may manage different points of the building simulation system. For this example, each system and virtual node may be associated with a different data file, stored with or as part of data file 216.

Each virtual node 304 may include a virtual node supervisor 312 to monitor the operations of the virtual node and oversee the activity of multiple servers 314, 316, 318 managing these operations. The virtual node supervisor 312 also enables communication with other components of the virtual node hosting environment 302 as well as the components of other virtual nodes. The virtual node supervisor 312 may manage a service supervisor server 314 to supervise the services 306, 308, 310 of the virtual node 304. If a service ceases to operate properly or dies, the service supervisor server 314 may spawn a replacement service or restart the service and clean-up resources related to the service. The virtual node supervisor may also manage a database server 316 to provide data storage for the servers and services for the duration of the existence of the virtual node. Information that may be stored by the database service 316 include, but are not limited to, configuration files 320 associated with one or more components of the virtual node 304 and data files 322 referenced by the configuration files. The virtual node supervisor may further manage a network server, such as a BACnet server 318, to provide data communications for various components throughout, and external to, the building automation system 100. For example, the BACnet server 318 shown in FIG. 3 may provide communications between a point simulation service of the virtual node 304 and a data consumer 106.

A data consumer 106 may request or otherwise receive simulated data from the virtual node 304 of the virtual node hosting environment 302 and provide simulated operation data to one or more data consumers 106. The simulated operation data may be the simulated data, analytical data based on the simulated data, or a combination of simulated and analytical data. Rather than communicate with other components of the building automation system 100, the data consumer 106 accesses the virtual node 304 and receives simulated operation data generated and/or stored at the virtual node 304.

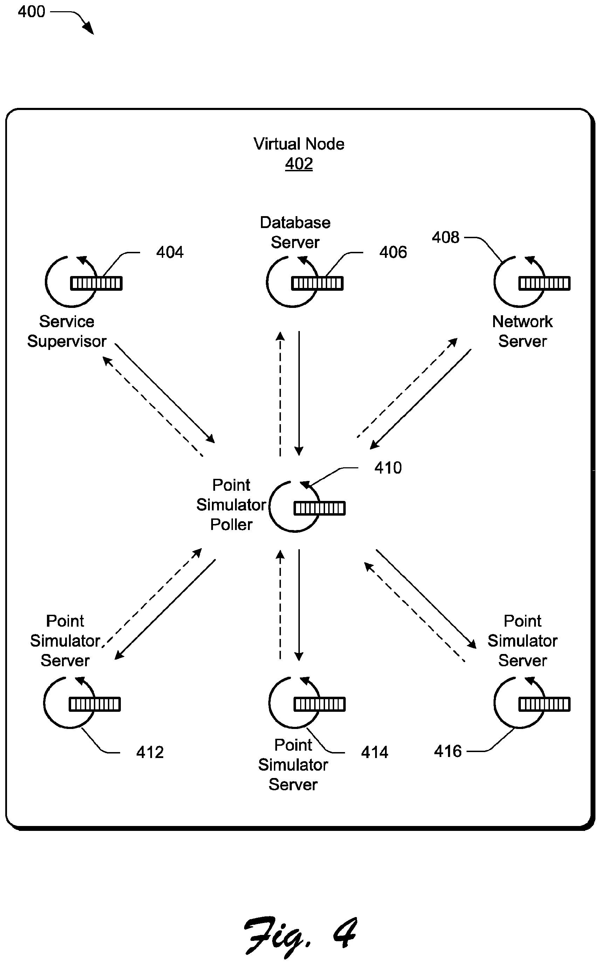

FIG. 4 illustrates example operational components 400 of a virtual node 402 for management and operation of the point simulator service, which may be implemented for the components of FIG. 3, as managed by virtual node 402 (e.g., such as service 306, 308, and 310). The virtual node 402 includes a service supervisor server 404, a database server 406, and a network server 408, similar to the representation of the building simulation system 300 of FIG. 3. The service supervisor server 404 generally manages the services of the virtual node 402, the database server 406 provides data storage for the servers and services of the virtual node, and the network server 408 provides data communications for various components throughout, and external to, the building automation system 100. For example, as described above, the network server 408 may provide communications between the point simulation service of the virtual node 402 and a data consumer 106.

The virtual node 402 includes a point simulator poller 410 which may communicate directly or indirectly with the service supervisor server 404, the database server 406, and the network server 408. The point simulator poller 410 may poll point simulator servers and, optionally, poll other servers for data corresponding to actual devices as well. The virtual node 402 may spawn the point simulator poller 410 in response to receiving an instruction from the management device, such as the processor 208 or I/O interface 218, to generate a point simulator service. For example, the virtual node 402 may spawn the point simulator poller 410 by reading or execution of a configuration file by the management device. Also, the point simulator poller 410 may communicate with the network service 408 or via the service supervisor 404 or the database server 406. While configuring the building simulation system executing the point simulator service in the virtual node 402, the point simulator poller 410 may receive data, such as data from configuration files and/or data files, from the database server 406 to create multiple point simulator servers 412, 414, 416. Similarly, while generating simulated operation data from the building simulation system executing the point simulator service in the virtual node 402, the point simulator poller 410 may receive data from the database server 406 and operate the multiple point simulator servers 412, 414, 416. The building simulation system executing the point simulator service may be configured in the virtual node 402 based on a configuration file of the database server 406 associated with the virtual node, and the configuration file may reference a data file that includes time intervals and multiple simulated system operation conditions of one or more points associated with one or more field devices for the time intervals. Each point simulator server 412, 414, 416 may represent one or more points or simulated system operation conditions of the field device or devices. For example, the point simulator poller 410 may create a point simulator server for each point identified by the data file referenced by the configuration file.

The point simulator poller 410 may receive data, such as data from configuration files and/or data files, from the database server 406 and send messages to one or more point simulator servers 412, 414, 416 based on the received data. The point simulator poller 410 may synchronize some or all point simulator servers 412, 414, 416 of the virtual node 402 to update their values, so that each point is represented at a synchronized, predetermined time. In particular, the point simulator poller 410 may include a clock or timing circuit, and the configuration file may indicate a point polling period to define a time interval for delivering simulated operation data to a data consumer 106 via the network server 408. For one embodiment, the point simulator poller 410 may send messages to the servers 412, 414, 416, based on the point polling period or time interval in seconds or other basis for time measurement. For another embodiment, the point simulator poller 410 may send messages to the servers 412, 414, 416, specifying the point polling period or time interval for receiving return messages from the servers. For yet another embodiment, the point simulator poller 410 may receive messages to the servers 412, 414, 416, and send messages to the network server 408 and/or data consumers 106 based on the point polling period or time interval.

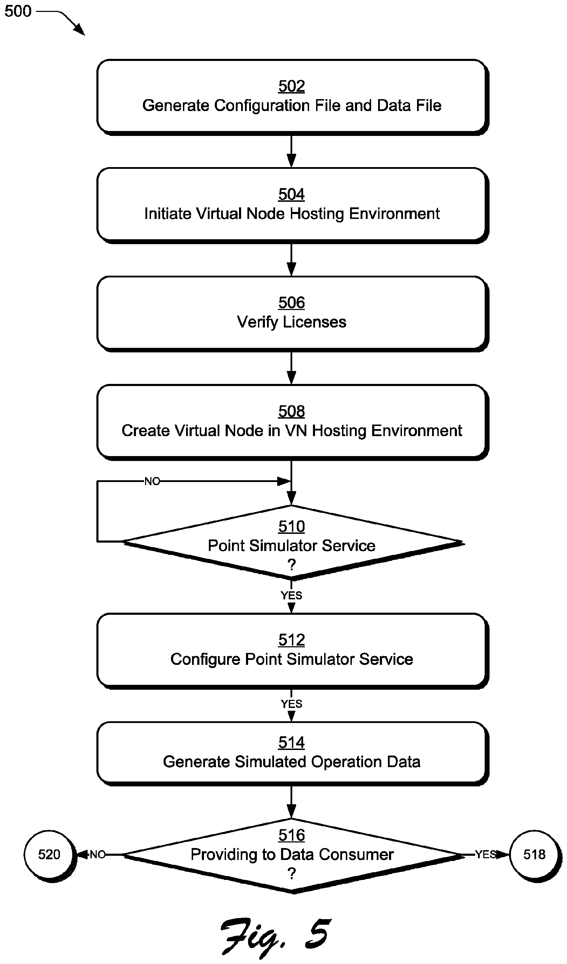

FIG. 5 represents an example operation 500 of a building simulation system, including a point simulator service, for simulating system operation conditions of a building or group of buildings. At some time before generating the point simulator service, the configuration file 214, 320 and the data file 216, 322 are generated and stored in the memory components 210 and accessible via the database server 316, 406. FIG. 5 illustrates an embodiment where the configuration file 214, 320 and the data file 216, 322 are generated in advance at step 502, such as prior to generating the virtual node hosting environment and creation of one or more virtual nodes in the environment, but it is to be understood that FIG. 5 is merely a representation of a particular embodiment and the files may be generated any time before utilization by the point simulator service. It is also to be understood that the configuration file and the data file may be combined into a single file or distributed among three or more files, depending on the implementation of the point simulator service.

The configuration file 214, 320 includes device properties of a field device simulated by the point simulator service. The device properties of the field device may include various information about the field device, such as a device name and a network location of the field device. The configuration file 214, 320 may reference a data file 216, 322 that includes multiple time intervals and one or more simulated system operation conditions of one or more points associated with the field device or devices for the multiple time intervals. The configuration file 214, 320 may further include a polling interval, so that the simulated point data may be generated by polling the simulated point data from the multiple point simulator servers based on the polling interval.

For some embodiments, a first version of the data file 216, 322 may be generated from non-simulated data received from the field device associated with the virtual node, and a second version of the data file may be generated from the first version of the data file, in which the second version is different from the first version. Non-simulated data refers to any type of data that is not simulated, such as actual data collected from one or more field devices of the building automation system. For this embodiment, the second version of the data file 216, 322 is referenced by the configuration file 214, 320 and used to generate the simulated operational data. The second version of the data file may be generated from the first version of the data file in various ways. For one example, the first version of the data file 216, 322 may be modified via a user interface of the building automation system to include one or more particular system operation conditions not represented by the non-simulated data received from the field device. For another example, the first version of the data file 216, 322 may be modified based on a supplemental data file that includes one or more particular system operation conditions not represented by the non-simulated data received from the field device.

The virtual node hosting environment 302 may be generated at the management device 104 by the processor 208 or other component of the management device 104 at step 504. For some embodiments, the building simulation system may include an application or device to provide licensing verification for one or more components of the building simulation system at step 506. The building simulation system provides several options for configuration, such as management and control over the desired output, data source, installation, and configuration. Another option for configuration is management and control over the type of license needed for each of these other options, such as a license for accessing, installing, and/or configuring the output, data source, or components of the building automation system associated with the output or data source. For example, the building simulation system may need a license to manage a predetermined quantity of points. For other examples, licensing may be based on a number of nodes supported, number of BASs supported, amount of data to be collected, and the like. The licensing information may be in the form of code or instructions provided in the system and/or entered by an administrator of the system. In other implementations, a physical device such as a fob may be employed. In yet other implementations, other operational parameters or number of elements (e.g., devices or points in the BAS to be accessed) may be licensed.

Once licensing has been verified at step 506, or where licensing is not required or implemented, one or more virtual nodes 304, 402 may be created in the virtual node hosting environment 302 at step 508. The virtual node hosting environment 302 allocates memory and processor resources to each virtual node 304, 402 via the memory components 210 and the processor 208 respectively. The virtual node 304, 402 may communicate with one or more data consumers 106 by a communication component, such as communication components 204. For example, the virtual node 304, 402 may communicate with the data consumer 106 by a network server 408, such as the BACnet server 318.

Subsequent to creating a virtual node 304, 402 at step 508, the building simulation system may detect an initiation of a request for the point simulation service at step 510. The point simulation service is generated in response to the request, if the point simulation service does not already exist. For some embodiments, the building simulation system and/or point simulator service may be initiated by an activation from the user interface 220 of the I/O interfaces 218 of the management device 104. For other embodiments, the building simulation system and/or point simulator service may be initiated by the processor 208 based on a determination that one or more conditions, stored in the memory components 210, have been met or exceeded. For yet other embodiments, the building simulation system and/or point simulator service may be initiated by a signal or message received by the communication components 204 of the management device 104. For still other embodiments, the building simulation system and/or point simulator service many be initiated automatically in response to creation of the corresponding virtual node 304, 402.

Regardless of when the configuration file 214, 320 and the data file 216, 322 are generated, the building simulation system executing the point simulator service may be configured at step 512, subsequent to generations of these files and the creation of the virtual node 304, 402. For example, the processor 208 may configure a building simulation system executing the point simulator service in the virtual node 304, 402 based on a configuration file 214, 320 associated with the virtual node. When configuring the building simulation system and/or point simulator service, multiple point simulator servers may be created based on system operation conditions identified by the data file.

Thereafter, the simulated operation data of a field device may be generated from the building simulation system executing the point simulator service, at step 514, in response to configuring the building simulation system. For example, the processor may generate the simulated operation data of one or more points from the point simulator service based on the data file 216, 322 as described in further detail herein. The point simulator service may include multiple point simulator servers 412, 414, 416, in which each point simulator server of the multiple point simulator servers corresponds to one or more system operation conditions identified by the data file 216, 322. For some embodiments, the simulated point data associated with the point or points from the multiple point simulator servers of the point simulator service may be received at a point simulator poller, and the point simulator poller may generate the simulated operation data of the point or points from the simulated point data of the multiple point simulator servers. As stated above, the configuration file 214, 320 may further include a polling interval. Thus, the simulated point data may be generated by polling the simulated point data from the multiple point simulator servers based on the polling interval. For example, the simulated operation data may be generated by polling the simulated point data at a rate different from that represented by the time intervals of the data file. For this example, the simulated point data may be polled at a rate faster or slower than the rate represented by the sequence of dates and/or times indicated by the data file. In the manner, the timing of the point simulation service may be controlled to accelerate product development by simulating events of interest within a shorter period of time or enhance analyses by focusing on events of interest at optimal time intervals.

The building simulation system executing the point simulator service may provide the simulated operation data to the data consumer 106. For example, the processor 208 of the management device 104 may determine whether to provide the simulated operation data via the communication components 204 at step 516. As stated above, the configuration file 214, 320 may further include a polling interval. Thus, similar to generating the simulated operation data, the simulated point data may be provided by providing the simulated operation data to the data consumer based on a timing interval associated with the polling interval. For example, the simulated operation data may be provided by providing the simulated point data at a rate different from that represented by the time intervals of the data file. For this example, the simulated point data may be provided at a rate faster or slower than the rate represented by the sequence of dates and/or times indicated by the data file.

If the point simulator service determines that the simulated operation data should be provided, either by an activation from the user interface 220 of the I/O interfaces 218 or a determination by the processor 208 based on one or more conditions, then the communication components 204 may provide the simulated operation data to the data consumer 106 at step 518. If the point simulator service determines that the simulated operation data should not be provided, either by an activation from the user interface 220 of the I/O interfaces 218 or a determination by the processor 208 based on one or more conditions, then the communication components 204 may not provide the simulated operation data to the data consumer 106 at step 520. For other embodiments, the point simulator service may also provide the simulated operation data automatically to the data consumer 106 in response to generation of the simulated operation data. For still other embodiments, other steps may be associated with various simulations options. For example, if the user requests a different condition for a point under simulation by the point simulator service, the corresponding virtual node may change the point in the data file of database or cause the point simulator to pause and accept the different condition based on the device or object name of the simulated device.

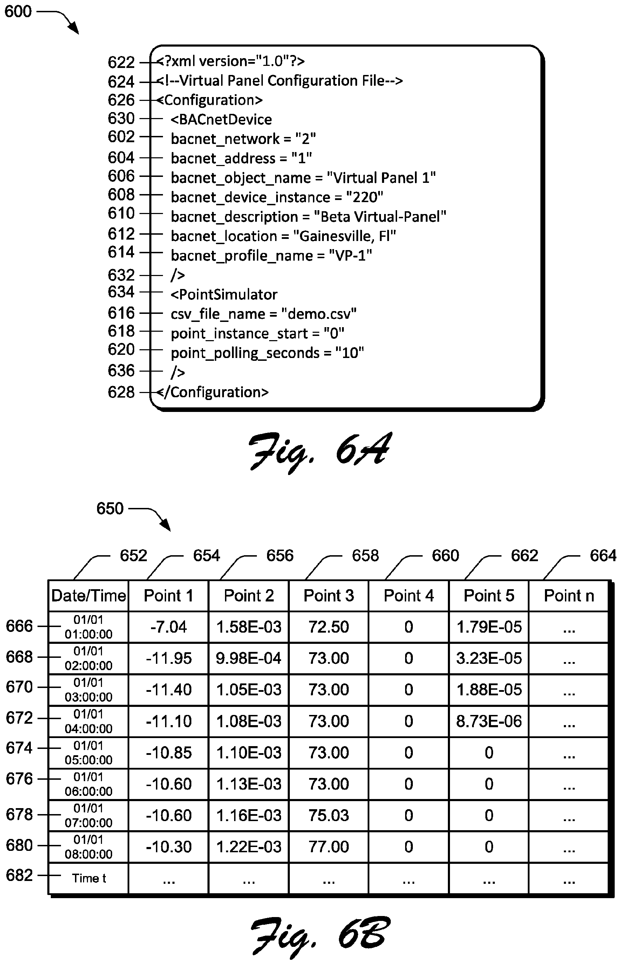

FIG. 6A represents an example configuration file 600 which illustrates a general file structure for the configuration file. In particular, the configuration file 600 may provide device properties of a field device simulated by a building simulation system executing the point simulator service. Examples of device properties include, but are not limited to, a network identifier 602, a network location or address identifier 604, a device or object name 606, a device instance 608 (i.e., sequential identifier for a starting point of operation), a device description 610, a device location 612, and a profile name 614. The configuration file 600 may also provide, in addition or alternative to the device properties, point simulator properties of the point simulator service. The point simulator properties may include, but are not limited to, a reference to a data file such as a data file name 616, a point instance start 618 (i.e., sequential identifier for a starting point of operation), and a point polling period or time interval 620. For example, for the device properties and point simulator properties described above, the device instance 608 and/or point instance start 618 may determine where to start a simulation among a list of data points prior to scaling or modifying the data to create simulated data. The configuration file 600 may further provide other information for the general file structure including, but not limited to, a programming language or script version 622, code commentary 624, a header and footer for the configuration body 626, 628, a header and footer for the device properties 630, 632, and a header and footer for the point simulator properties 634, 636.

As stated above, the point simulator properties may include a point instance start 618. It should be noted that, in a general sense, the configuration file may further include a data subset. For some embodiments, the simulated operation data may be generated by the processor 208 by polling a particular subset of the simulated point data from the point simulator servers based on the data subset. For other embodiments, the simulated operation data may be provided by the communication component 204 by providing a particular subset of the simulated operation data to the data consumer based on the data subset. The data subset may specify a beginning of a subset, an ending of a subset, multiple groups of subsets, or a combination of these specifications.

FIG. 6B represents an example data file 650 which illustrates a general data structure for the data file. The data files may include, but are not limited to points associated with the building automation system and their corresponding values associated with system operation conditions over a particular period of time. In particular, the data file 650 may include multiple time intervals 652 and one or more points 654-664 representing simulated system operation conditions of field devices for multiple time intervals. For example, as shown by the example embodiment of FIG. 6B, the time intervals 652 may be represented by the rows 666-682 within a particular column and the points 654-664 may be represented by the columns aligned with the column for the time intervals. The point simulator poller 410 may read information of the data file 650 to instantiate the point simulator servers 412, 414, 416. The point simulator servers 412, 414, 416 may process data back to the point simulator poller 410 as the point simulator poller 410 steps through the data. Examples of points include, but are not limited to:
- environmental data including temperatures and humidity;
- cooling system data including system cycle status, demand rate, flow rate, chiller temperature, chiller part load ratio, chiller coefficient of performance, and electric energy;
- heating system data including system cycle status, demand rate, flow rate, boiler temperature, boiler part load ratio, boiler coefficient of performance, and electric energy;
- solar water heating system data;
- tower water system data;
- valve data including system cycle status, air economizer status, air flow fraction, heating energy, cooling energy, fan electric energy, and heating coil hot water energy;
- electricity data including facility, fans, cooling, heating, lights, and equipment;
- gas data;
- air quality data including carbon dioxide, carbon monoxide, methane, oxides of nitrogen, nitrous oxide, sulfur dioxide, particulate matter, anhydrous ammonia, non-methane volatile organic compounds, mercury, and lead; and
- water quality.

It is important to note that while the disclosure includes a description in the context of a fully functional system, those skilled in the art will appreciate that at least portions of the mechanism of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

Although an example embodiment of the present disclosure has been described in detail, those skilled in the art will understand that various changes, substitutions, variations, and improvements disclosed herein may be made within the scope of the appended claims.

## Claims

1. A building simulation system (102, 300) for simulating system operation conditions associated with a building automation system (100) comprising:
a memory having a configuration file (320) associated with at least one virtual node (304), the configuration file (320) including at least one device property of a field device (112, 114, 116) simulated by the building simulation system (102, 300), the configuration file (320) referencing a data file (322) that includes a plurality of time intervals and a plurality of simulated system operation conditions of at least one point associated with the field device (112, 114, 116) for the plurality of time intervals;
a processor, coupled to the memory, executing instructions for generating a virtual node hosting environment (302), creating the at least one virtual node (304) in the virtual hosting environment (302), generating simulated operation data of the at least one point from the building simulation system (102, 300) based on the data file (322), the building simulation system (102, 300) including a plurality of point simulator servers (412, 414, 416), wherein each point simulator server of the plurality of point simulator servers (412, 414, 416) corresponds to the at least one system operation condition of the plurality of simulated system operation conditions identified by the data file (322); and
a communication component coupled to the processor that provides the simulated operation data to a data consumer (106);
**characterized in that**
the building model of the building automation (100) system includes various simulated conditions and fault events that are being used for testing new data analytics and optimization applications, wherein a play back of these fault events, via the virtual node hosting environment (302), validates the detection capabilities of monitoring systems by detecting the various played back faults.

2. The system described by claim 1, wherein:
the configuration file (320) further includes a polling interval; and
the processor polls the simulated point data from the plurality of point simulator servers (412, 414, 416) based on the polling interval.

3. The system described by claim 2, wherein the processor polls the simulated point data at a rate different from that represented by the plurality of time intervals of the data file (322).

4. The system described by claim 1, wherein:
the configuration file (320) further includes a polling interval; and
the communication component provides the simulated operation data to the data consumer (106) based on a timing interval associated with the polling interval.

5. The system described by claim 4, wherein the communication component provides the simulated point data at a rate different from that represented by the plurality of time intervals of the data file (322).

6. The system described by claim 1, wherein:
the configuration file (320) further includes a data subset; and
the processor polls a particular subset of the simulated point data from the plurality of point simulator servers (412, 414, 416) based on the data subset.

7. The system described by claim 1, wherein:
the configuration file (320) further includes a data subset; and
the communication component provides a particular subset of the simulated operation data to the data consumer (106) based on the data subset.

8. A method of a building simulation system (102, 300) for simulating system operation conditions associated with a building automation system (100) comprising:
generating a virtual node hosting environment (302) by a processor;
creating at least one virtual node (304) in the virtual node hosting environment (302) to communicate with a data consumer (106) by a communication component, wherein the virtual node hosting environment (302) allocates memory and processor resources to the at least one virtual node (304);
configuring, by the processor, a building simulation system (102, 300) in the at least one virtual node (304) based on a configuration file (320) associated with the at least one virtual node (304), the configuration file (320) including at least one device property of a field device (112, 114, 116) simulated by the building simulation system (102, 300), the configuration file (320) referencing a data file (322) that includes a plurality of time intervals and a plurality of simulated system operation conditions of at least one point associated with the field device (112, 114, 116) for the plurality of time intervals;
generating, by the processor, simulated operation data of the at least one point from the building simulation system (102, 300) based on the data file (322), the building simulation system (102, 300) including a plurality of point simulator servers (412, 414, 416), wherein each point simulator server of the plurality of point simulator servers (412, 414, 416) corresponds to at least one system operation condition of the plurality of simulated system operation conditions identified by the data file (322); and
providing, by the communication component, the simulated operation data to the data consumer (106);
**characterized in that**
the building model of the building automation (100) system includes various simulated conditions and fault events that are be used for testing new data analytics and optimization applications, wherein a play back of these fault events, via the virtual node hosting environment (302), validates the detection capabilities of monitoring systems by detecting the various played back faults.

9. The method described by claim 8, wherein:
the configuration file (320) further includes a polling interval; and
generating the simulated operation data includes polling the simulated point data from the plurality of point simulator servers (412, 414, 416) based on the polling interval.

10. The method described by claim 9, wherein generating the simulated operation data includes polling the simulated point data at a rate different from that represented by the plurality of time intervals of the data file (322).

11. The method described by claim 8, wherein:
the configuration file (320) further includes a polling interval; and
providing the simulated operation data includes providing the simulated operation data to the data consumer (106) based on a timing interval associated with the polling interval.

12. The method described by claim 11, wherein providing the simulated operation data includes providing the simulated point data at a rate different from that represented by the plurality of time intervals of the data file (322).

13. The method described by claim 8, wherein:
the configuration file (320) further includes a data subset; and
generating the simulated operation data includes polling a particular subset of the simulated point data from the plurality of point simulator servers (412, 414, 416) based on the data subset.

14. The method described by claim 8, wherein:
the configuration file (320) further includes a data subset; and
providing the simulated operation data includes providing a particular subset of the simulated operation data to the data consumer (106) based on the data subset.

15. A non-transitory computer readable medium including executable instructions which, when executed, cause at least one processor to provide for simulation of system operation conditions associated with a building automation system (100) by:
generating a virtual node hosting environment (302);
creating at least one virtual node (304) in the virtual node hosting environment (302) to communicate with a data consumer (106) by a communication component;
configuring a building simulation system (102, 300) in the at least one virtual node (304) based on a configuration file (320) associated with the at least one virtual node (304), the configuration file (320) including at least one device property of a field device (112, 114, 116) simulated by the building simulation system (102, 300), the configuration file (320) referencing a data file (322) that includes a plurality of time intervals and a plurality of simulated system operation conditions of at least one point associated with the field device (112, 114, 116) for the plurality of time intervals;
generating simulated operation data of the at least one point from the building simulation system (102, 300) based on the data file (322), the building simulation system (102, 300) including a plurality of point simulator servers (412, 414, 416), wherein each point simulator server of the plurality of point simulator servers (412, 414, 416) corresponds to at least one point of the plurality of points identified by the data file (322); and
providing the simulated operation data of the field device (112, 114, 116) to the data consumer (106);
**characterized in that**
the building model of the building automation (100) system includes various simulated conditions and fault events that are be used for testing new data analytics and optimization applications, wherein a play back of these fault events, via the virtual node hosting environment (302), validates the detection capabilities of monitoring systems by detecting the various played back faults.

## Patentansprüche

1. Gebäudesimulationssystem (102, 300) zum Simulieren von mit einem Gebäudeautomationssystem (100) verknüpften Systembetriebsbedingungen, das Folgendes umfasst:
einen Speicher mit einer Konfigurationsdatei (320), die mit mindestens einem virtuellen Knoten (304) verknüpft ist, wobei die Konfigurationsdatei (320) mindestens eine von dem Gebäudesimulationssystem (102, 300) simulierte
Geräteeigenschaft eines Feldgeräts (112, 114, 116) enthält, wobei die Konfigurationsdatei (320) eine Datendatei (322) referenziert, die mehrere Zeitintervalle und mehrere simulierte Systembetriebsbedingungen für die mehreren Zeitintervalle für mindestens einen mit dem Feldgerät (112, 114, 116) verknüpften Punkt enthält,
einen mit dem Speicher gekoppelten Prozessor, der Anweisungen zum Erzeugen einer Hosting-Umgebung (302) für virtuelle Knoten ausführt, den mindestens einen virtuellen Knoten (304) in der virtuellen Hosting-Umgebung (302) erstellt, auf der Grundlage der Datendatei (322) simulierte Betriebsdaten für den mindestens einen Punkt aus dem Gebäudesimulationssystem (102, 300) erzeugt, wobei das Gebäudesimulationssystem (102, 300) mehrere Punktsimulatorserver (412, 414, 416) aufweist, wobei jeder unter den mehreren Punktsimulatorservern (412, 414, 416) der mindestens einen Systembetriebsbedingung unter den mehreren simulierten Systembetriebsbedingungen entspricht, die in der Datendatei (322) angegeben sind, und
eine mit dem Prozessor gekoppelte Kommunikationskomponente, die die simulierten Betriebsdaten für einen Datenanwender (106) bereitstellt,
**dadurch gekennzeichnet, dass**
das Gebäudemodell für das Gebäudeautomationssystem (100) verschiedene simulierte Bedingungen und Fehlerereignisse enthält, die zum Testen neuer Datenanalyse- und Optimierungsanwendungen benutzt werden, wobei durch eine Wiedergabe dieser Fehlerereignisse über die Hosting-Umgebung (302) für virtuelle Knoten die Erkennungsfähigkeiten von Überwachungssystemen durch Erkennen der verschiedenen wiedergegebenen Fehler validiert werden.

2. System nach Anspruch 1, wobei:
die Konfigurationsdatei (320) ferner ein Abfrageintervall enthält und
der Prozessor auf der Grundlage des Abfrageintervalls die simulierten Punktdaten bei den mehreren Punktsimulatorservern (412, 414, 416) abfragt.

3. System nach Anspruch 2, wobei der Prozessor die simulierten Punktdaten mit einer anderen Rate abfragt als der, die die mehreren Zeitintervalle der Datendatei (322) repräsentieren.

4. System nach Anspruch 1, wobei:
die Konfigurationsdatei (320) ferner ein Abfrageintervall enthält und
die Kommunikationskomponente die simulierten Betriebsdaten auf der Grundlage eines mit dem Abfrageintervall verknüpften Zeitgabeintervalls für den Datenanwender (106) bereitstellt.

5. System nach Anspruch 4, wobei die Kommunikationskomponente die simulierten Punktdaten mit einer anderen Rate bereitstellt als der, die die mehreren Zeitintervalle der Datendatei (322) repräsentieren.

6. System nach Anspruch 1, wobei:
die Konfigurationsdatei (320) ferner einen Teildatensatz enthält und
der Prozessor auf der Grundlage des Teildatensatzes einen bestimmten Teilsatz der simulierten Punktdaten bei den mehreren Punktsimulatorservern (412, 414, 416) abfragt.

7. System nach Anspruch 1, wobei:
die Konfigurationsdatei (320) ferner einen Teildatensatz enthält und
die Kommunikationskomponente auf der Grundlage des Teildatensatzes einen bestimmten Teilsatz der simulierten Betriebsdaten für den Datenanwender (106) bereitstellt.

8. Verfahren für ein Gebäudesimulationssystem (102, 300) zum Simulieren von mit einem Gebäudeautomationssystem (100) verknüpften Systembetriebsbedingungen, das Folgendes umfasst:
Erzeugen einer Hosting-Umgebung (302) für virtuelle Knoten durch einen Prozessor,
Erstellen mindestens eines virtuellen Knotens (304) in der Hosting-Umgebung (302) für virtuelle Knoten für das Kommunizieren mit einem Datenanwender (106) durch eine Kommunikationskomponente, wobei die Hosting-Umgebung (302) für virtuelle Knoten dem mindestens einen virtuellen Knoten (304) Speicher- und Prozessorressourcen zuweist,
Konfigurieren eines Gebäudesimulationssystems (102, 300) in dem mindestens einen virtuellen Knoten (304) durch den Prozessor auf der Grundlage einer mit dem mindestens einen virtuellen Knoten (304) verknüpften Konfigurationsdatei (320), die mindestens eine von dem Gebäudesimulationssystem (102, 300) simulierte Geräteeigenschaft eines Feldgeräts (112, 114, 116) enthält, wobei die Konfigurationsdatei (320) eine Datendatei (322) referenziert, die mehrere Zeitintervalle und mehrere simulierte Systembetriebsbedingungen für die mehreren Zeitintervalle für mindestens einen Punkt enthält, der mit dem Feldgerät (112, 114, 116) verknüpft ist,
Erzeugen simulierter Betriebsdaten für den mindestens einen Punkt aus dem Gebäudesimulationssystem (102, 300) durch den Prozessor auf der Grundlage der Datendatei (322), wobei das Gebäudesimulationssystem (102, 300) mehrere Punktsimulatorserver (412, 414, 416) aufweist, wobei jeder unter den mehreren Punktsimulatorservern (412, 414, 416) mindestens einer Systembetriebsbedingung unter den mehreren simulierten Systembetriebsbedingungen entspricht, die in der Datendatei (322) angegeben sind, und
Bereitstellen der simulierten Betriebsdaten für den Datenanwender (106) durch die Kommunikationskomponente,
**dadurch gekennzeichnet, dass**
das Gebäudemodell für das Gebäudeautomationssystem (100) verschiedene simulierte Bedingungen und Fehlerereignisse enthält, die zum Testen neuer Datenanalyse- und Optimierungsanwendungen benutzt werden, wobei durch eine Wiedergabe dieser Fehlerereignisse über die Hosting-Umgebung (302) für virtuelle Knoten die Erkennungsfähigkeiten von Überwachungssystemen durch Erkennen der verschiedenen wiedergegebenen Fehler validiert werden.

9. Verfahren nach Anspruch 8, wobei:
die Konfigurationsdatei (320) ferner ein Abfrageintervall enthält und
das Erzeugen der simulierten Betriebsdaten das Abfragen der simulierten Punktdaten bei den mehreren Punktsimulatorservern (412, 414, 416) auf der Grundlage des Abfrageintervalls umfasst.

10. Verfahren nach Anspruch 9, wobei das Erzeugen der simulierten Betriebsdaten das Abfragen der simulierten Punktdaten mit einer anderen Rate als der umfasst, die die mehreren Zeitintervalle der Datendatei (322) repräsentieren.

11. Verfahren nach Anspruch 8, wobei:
die Konfigurationsdatei (320) ferner ein Abfrageintervall enthält und
das Bereitstellen der simulierten Betriebsdaten das Bereitstellten der simulierten Betriebsdaten für den Datenanwender (106) auf der Grundlage eines mit dem Abfrageintervall verknüpften Zeitgabeintervalls umfasst.

12. Verfahren nach Anspruch 11, wobei das Bereitstellen der simulierten Betriebsdaten das Bereitstellen der simulierten Punktdaten mit einer anderen Rate als der umfasst, die die mehreren Zeitintervalle der Datendatei (322) repräsentieren.

13. Verfahren nach Anspruch 8, wobei:
die Konfigurationsdatei (320) ferner einen Teildatensatz enthält und
das Erzeugen der simulierten Betriebsdaten das Abfragen eines bestimmten Teilsatzes der simulierten Punktdaten bei den mehreren Punktsimulatorservern (412, 414, 416) auf der Grundlage des Teildatensatzes umfasst.

14. Verfahren nach Anspruch 8, wobei:
die Konfigurationsdatei (320) ferner einen Teildatensatz enthält und
das Bereitstellen der simulierten Betriebsdaten das Bereitstellen eines bestimmten Teilsatzes der simulierten Betriebsdaten für den Datenanwender (106) auf der Grundlage des Teildatensatzes umfasst.

15. Nichtflüchtiges, computerlesbares Medium mit ausführbaren Anweisungen, die, wenn sie ausgeführt werden, mindestens einen Prozessor dazu veranlassen, für eine Simulation von Systembetriebsbedingungen zu sorgen, die mit einem Gebäudeautomationssystem (100) verknüpft sind, durch:
Erzeugen einer Hosting-Umgebung (302) für virtuelle Knoten, Erstellen mindestens eines virtuellen Knotens (304) in der Hosting-Umgebung (302) für virtuelle Knoten für das Kommunizieren mit einem Datenanwender (106) über eine Kommunikationskomponente,
Konfigurieren eines Gebäudesimulationssystems (102, 300) in dem mindestens einen virtuellen Knoten (304) auf der Grundlage einer mit dem mindestens einen virtuellen Knoten (304) verknüpften Konfigurationsdatei (320), die mindestens eine von dem Gebäudesimulationssystem (102, 300) simulierte Geräteeigenschaft eines Feldgeräts (112, 114, 116) enthält,
wobei die Konfigurationsdatei (320) eine Datendatei (322) referenziert, die mehrere Zeitintervalle und mehrere simulierte Systembetriebsbedingungen für die mehreren Zeitintervalle für mindestens einen Punkt enthält, der mit dem Feldgerät (112, 114, 116) verknüpft ist,
Erzeugen simulierter Betriebsdaten für den mindestens einen Punkt aus dem Gebäudesimulationssystem (102, 300) auf der Grundlage der Datendatei (322), wobei das Gebäudesimulationssystem (102, 300) mehrere Punktsimulatorserver (412, 414, 416) aufweist, wobei jeder unter den mehreren Punktsimulatorservern (412, 414, 416) mindestens einem unter den mehreren Punkten entspricht, die in der Datendatei (322) angegeben sind, und
Bereitstellen der simulierten Betriebsdaten des Feldgeräts (112, 114, 116) für den Datenanwender (106),
**dadurch gekennzeichnet, dass**
das Gebäudemodell für das Gebäudeautomationssystem (100) verschiedene simulierte Bedingungen und Fehlerereignisse enthält, die zum Testen neuer Datenanalyse- und Optimierungsanwendungen benutzt werden, wobei durch eine Wiedergabe dieser Fehlerereignisse über die Hosting-Umgebung (302) für virtuelle Knoten die Erkennungsfähigkeiten von Überwachungssystemen durch Erkennen der verschiedenen wiedergegebenen Fehler validiert werden.

## Revendications

1. Système de simulation de bâtiment (102, 300) destiné à simuler des conditions de fonctionnement de système associées à un système d'automatisation de bâtiment (100), comprenant :
une mémoire présentant un fichier de configuration (320) associé à au moins un noeud virtuel (304), le fichier de configuration (320) incluant au moins une propriété de dispositif d'un dispositif de terrain (112, 114, 116) simulé par le système de simulation de bâtiment (102, 300), le fichier de configuration (320) référençant un fichier de données (322) qui inclut une pluralité d'intervalles de temps et une pluralité de conditions de fonctionnement de système simulées d'au moins un point associé au dispositif de terrain (112, 114, 116) pour la pluralité d'intervalles de temps ;
un processeur, couplé à la mémoire, exécutant des instructions pour générer un environnement d'hébergement de noeuds virtuels (302), créer le au moins un noeud virtuel (304) dans l'environnement d'hébergement de noeuds virtuels (302), générer des données de fonctionnement simulées du au moins un point à partir du système de simulation de bâtiment (102, 300) sur la base du fichier de données (322), le système de simulation de bâtiment (102, 300) incluant une pluralité de serveurs de simulateurs de points (412, 414, 416), dans lequel chaque serveur de simulateurs de points de la pluralité de serveurs de simulateurs de points (412, 414, 416) correspond à au moins une condition de fonctionnement de système de la pluralité de conditions de fonctionnement de système simulées identifiées par le fichier de données (322) ; et
un composant de communication couplé au processeur qui fournit les données de fonctionnement simulées à un consommateur de données (106) ;
**caractérisé en ce que** :
le modèle de bâtiment du système d'automatisation de bâtiment (100) inclut diverses conditions simulées et des événements de défaillance qui doivent être utilisés en vue de tester de nouvelles applications d'optimisation et d'analyse de données, dans lequel une lecture de ces événements de défaillance, par l'intermédiaire de l'environnement d'hébergement de noeuds virtuels (302), valide les capacités de détection de systèmes de surveillance en détectant les diverses défaillances lues.

2. Système selon la revendication 1, dans lequel :
le fichier de configuration (320) inclut en outre un intervalle d'interrogation ; et
le processeur interroge les données de points simulées à partir de la pluralité de serveurs de simulateurs de points (412, 414, 416) sur la base de l'intervalle d'interrogation.

3. Système selon la revendication 2, dans lequel le processeur interroge les données de points simulées à un rythme différent de celui représenté par la pluralité d'intervalles de temps du fichier de données (322).

4. Système selon la revendication 1, dans lequel :
le fichier de configuration (320) inclut en outre un intervalle d'interrogation ; et
le composant de communication fournit les données de fonctionnement simulées au consommateur de données (106) sur la base d'un intervalle de temporisation associé à l'intervalle d'interrogation.

5. Système selon la revendication 4, dans lequel le composant de communication fournit les données de points simulées à un rythme différent de celui représenté par la pluralité d'intervalles de temps du fichier de données (322).

6. Système selon la revendication 1, dans lequel :
le fichier de configuration (320) inclut en outre un sous-ensemble de données ; et
le processeur interroge un sous-ensemble spécifique des données de points simulées à partir de la pluralité de serveurs de simulateurs de points (412, 414, 416) sur la base du sous-ensemble de données.

7. Système selon la revendication 1, dans lequel :
le fichier de configuration (320) inclut en outre un sous-ensemble de données ; et
le composant de communication fournit un sous-ensemble spécifique des données de fonctionnement simulées au consommateur de données (106) sur la base du sous-ensemble de données.

8. Procédé d'un système de simulation de bâtiment (102, 300) destiné à simuler des conditions de fonctionnement de système associées à un système d'automatisation de bâtiment (100), comprenant les étapes ci-dessous :
générer un environnement d'hébergement de noeuds virtuels (302) par le biais d'un processeur ;
créer au moins un noeud virtuel (304) dans l'environnement d'hébergement de noeuds virtuels (302) pour communiquer avec un consommateur de données (106) par le biais d'un composant de communication, dans lequel l'environnement d'hébergement de noeuds virtuels (302) alloue des ressources de mémoire et de processeur au au moins un noeud virtuel (304) ;
configurer, par le biais du processeur, un système de simulation de bâtiment (102, 300) dans le au moins un noeud virtuel (304) sur la base d'un fichier de configuration (320) associé au au moins un noeud virtuel (304), le fichier de configuration (320) incluant au moins une propriété de dispositif d'un dispositif de terrain (112, 114, 116) simulé par le système de simulation de bâtiment (102, 300), le fichier de configuration (320) référençant un fichier de données (322) qui inclut une pluralité d'intervalles de temps et une pluralité de conditions de fonctionnement de système simulées d'au moins un point associé au dispositif de terrain (112, 114, 116) pour la pluralité d'intervalles de temps ;
générer, par le biais du processeur, des données de fonctionnement simulées du au moins un point à partir du système de simulation de bâtiment (102, 300), sur la base du fichier de données (322), le système de simulation de bâtiment (102, 300) incluant une pluralité de serveurs de simulateurs de points (412, 414, 416), dans lequel chaque serveur de simulateurs de points de la pluralité de serveurs de simulateurs de points (412, 414, 416) correspond à au moins une condition de fonctionnement de système de la pluralité de conditions de fonctionnement de système simulées identifiées par le fichier de données (322) ; et
fournir, par le biais du composant de communication, les données de fonctionnement simulées au consommateur de données (106) ;
**caractérisé en ce que** :
le modèle de bâtiment du système d'automatisation de bâtiment (100) inclut diverses conditions simulées et des événements de défaillance qui doivent être utilisés en vue de tester de nouvelles applications d'optimisation et d'analyse de données, dans lequel une lecture de ces événements de défaillance, par l'intermédiaire de l'environnement d'hébergement de noeuds virtuels (302), valide les capacités de détection de systèmes de surveillance en détectant les diverses défaillances lues.

9. Procédé selon la revendication 8, dans lequel :
le fichier de configuration (320) inclut en outre un intervalle d'interrogation ; et
l'étape de génération des données de fonctionnement simulées inclut l'étape consistant à interroger les données de points simulées à partir de la pluralité de serveurs de simulateurs de points (412, 414, 416) sur la base de l'intervalle d'interrogation.

10. Procédé selon la revendication 9, dans lequel l'étape de génération des données de fonctionnement simulées inclut l'étape consistant à interroger les données de points simulées à un rythme différent de celui représenté par la pluralité d'intervalles de temps du fichier de données (322).

11. Procédé selon la revendication 8, dans lequel :
le fichier de configuration (320) inclut en outre un intervalle d'interrogation ; et
l'étape de fourniture des données de fonctionnement simulées inclut l'étape consistant à fournir les données de fonctionnement simulées au consommateur de données (106) sur la base d'un intervalle de temporisation associé à l'intervalle d'interrogation.

12. Procédé selon la revendication 11, dans lequel l'étape de fourniture des données de fonctionnement simulées inclut l'étape consistant à fournir les données de points simulées à un rythme différent de celui représenté par la pluralité d'intervalles de temps du fichier de données (322).

13. Procédé selon la revendication 8, dans lequel :
le fichier de configuration (320) inclut en outre un sous-ensemble de données ; et
l'étape de génération des données de fonctionnement simulées inclut l'étape consistant à interroger un sous-ensemble spécifique de données de points simulées à partir de la pluralité de serveurs de simulateurs de points (412, 414, 416), sur la base du sous-ensemble de données.

14. Procédé selon la revendication 8, dans lequel :
le fichier de configuration (320) inclut en outre un sous-ensemble de données ; et
l'étape de fourniture des données de fonctionnement simulées inclut l'étape consistant à fournir un sous-ensemble spécifique des données de fonctionnement simulées au consommateur de données (106) sur la base du sous-ensemble de données.

15. Support non transitoire lisible par ordinateur incluant des instructions exécutables qui, lorsqu'elles sont exécutées, amènent au moins un processeur à fournir une simulation de conditions de fonctionnement de système associées à un système d'automatisation de bâtiment (100), en mettant en œuvre les étapes ci-dessous :
générer un environnement d'hébergement de noeuds virtuels (302) ;
créer au moins un noeud virtuel (304) dans l'environnement d'hébergement de noeuds virtuels (302) pour communiquer avec un consommateur de données (106) par le biais d'un composant de communication ;
configurer un système de simulation de bâtiment (102, 300) dans le au moins un noeud virtuel (304) sur la base d'un fichier de configuration (320) associé au au moins un noeud virtuel (304), le fichier de configuration (320) incluant au moins une propriété de dispositif d'un dispositif de terrain (112, 114, 116) simulé par le système de simulation de bâtiment (102, 300), le fichier de configuration (320) référençant un fichier de données (322) qui inclut une pluralité d'intervalles de temps et une pluralité de conditions de fonctionnement de système simulées d'au moins un point associé au dispositif de terrain (112, 114, 116) pour la pluralité d'intervalles de temps ;
générer des données de fonctionnement simulées du au moins un point à partir du système de simulation de bâtiment (102, 300), sur la base du fichier de données (322), le système de simulation de bâtiment (102, 300) incluant une pluralité de serveurs de simulateurs de points (412, 414, 416), dans lequel chaque serveur de simulateurs de points de la pluralité de serveurs de simulateurs de points (412, 414, 416) correspond à au moins un point de la pluralité de points identifiés par le fichier de données (322) ; et
fournir les données de fonctionnement simulées du dispositif de terrain (112, 114, 116) au consommateur de données (106) ;
**caractérisé en ce que** :
le modèle de bâtiment du système d'automatisation de bâtiment (100) inclut diverses conditions simulées et des événements de défaillance qui doivent être utilisés en vue de tester de nouvelles applications d'optimisation et d'analyse de données, dans lequel une lecture de ces événements de défaillance, par l'intermédiaire de l'environnement d'hébergement de noeuds virtuels (302), valide les capacités de détection de systèmes de surveillance en détectant les diverses défaillances lues.
